# EUROPEAN PATENT APPLICATION

(11) **EP 1 519 424 A1**
(43) Date of publication of application: **30.03.2005**
(21) Application number: 03256046.8
(22) Date of filing: 25.09.2003
(51) Int. Cl.: H01L 41/047, H01L 41/083, H01L 41/22

(54) **Piezoelectric actuator device**

(71) Applicant: Delphi Technologies, Inc., Troy, MI 48007 (US)
(72) Inventor: Cooke, Michael P., Gillingham, Kent ME7 1DR (GB); Goat, Christopher A., Offham, Kent ME19 5NU (GB); Sfakianakis, Stavros, Gillingham, Kent ME7 5SD (GB)
(74) Representative: Keltie, David Arthur

(57) **Abstract**

A piezoelectric device (30) comprises a stack (31) of one or more piezoelectric elements (42) and means for applying a voltage across the one or more piezoelectric elements (42), wherein the means includes a pair of opposing electrodes (44a, 44b) and positive and negative conductor members (36a, 36b) being received by respective first and second channels (32, 34) disposed internal to the stack (31) so as to make contact with the opposing electrode pair (44a, 44b).

## Description

The invention relates to a piezoelectric actuator device, more particularly but not exclusively a piezoelectric device suitable for use in fuel injectors of internal combustion engines.

Known piezoelectric fuel injectors typically employ piezoelectric actuators having a stack of piezoelectric elements arranged mechanically in series for opening and closing an injection valve to meter fuel injected into the engine. It is known to locate the piezoelectric actuator in a chamber containing fuel at injection pressures to control movement of a valve needle either by mechanical or hydraulic coupling. An example of a piezoelectric fuel injector is disclosed in U.S. Patent No. 6520423. For such applications in particular, known piezoelectric actuator devices have several limitations.

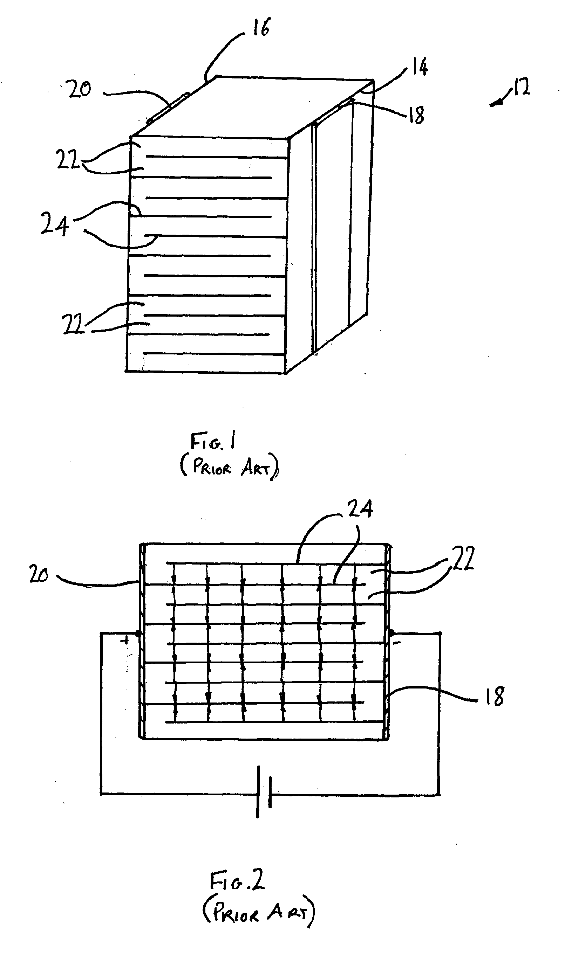

A typical multi-layer actuator or stack is shown in Figure 1 and comprises a generally rectangular stack body 12 having first and second opposing outer surfaces 14, 16 and associated first and second external conductors 18, 20. The body 12 comprises a plurality of relatively thin piezoelectric elements or layers 22, each of which is spaced from adjacent elements 22 by an internal electrode 24. Alternate ones of the internal electrodes 24 are electrically connected to the first external conductor 18 and second external conductor 20 respectively to comprise two groups of electrodes, whereby the electrodes of one group are interdigitated with the electrodes of the other group.

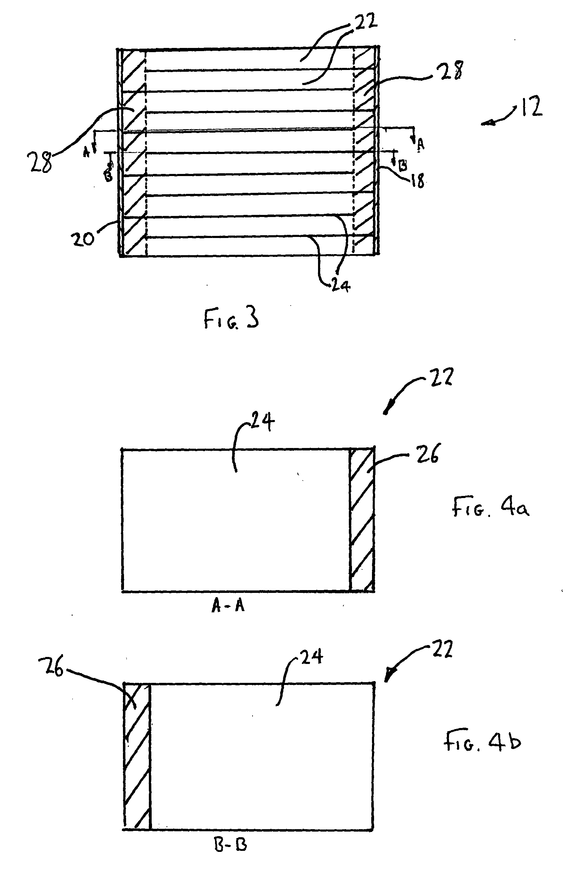

With reference to Figure 2, a voltage is applied across the two external conductors 18, 20 whereby an adjacent pair of internal electrodes 24 sandwiching a piezoelectric element 22 become mutual conductors of opposite polarity and apply an electric field to said element 22. Since each element has a typical thickness of around 100 µm, a sufficient electric field strength of, for example 2kV/mm, can be attained between the electrodes 24 by way of an applied voltage of 200V. Due to the alternating polarity of the electric fields generated between the internal electrodes 24, the poling direction of the elements 22 also alternates throughout the structure of the actuator.

Although existing multi-layer piezoelectric actuators succeed in lowering the required operational voltages, they have several associated problems that will now be discussed.

Electrical insulation between an external conductor and an internal electrode of opposite polarity must be ensured to enable an electric field to be established in the sandwiched material. Isolation of the two electrode groups is usually achieved by terminating each electrode of a respective group short of the opposite polarity conductor. As can be seen from Figures 3, 4a and 4b, each piezoelectric element 22 is coated with an electrode 24 over at least a part of its surface leaving a margin 26 where the element 22 is uncoated. When formed into a stack 12, the margins 26 of adjacent elements 22 are located on opposing sides of the stack 12 and create "in-active zones" 28 in the multi-layered stack 12 that will not be exposed to an electric field during operation. It is desirable to minimise the size of the inactive zones 28 since the energy provided by the electric field to each element 22 is partially dissipated by the inactive zones 28, thus, the maximum stroke of the stack 12 increases with a greater active area. However, a margin 26 must necessarily be maintained between the terminated edge of an internal electrode 24 of a first polarity and an external electrode 18, 20 of opposite polarity to avoid a short circuit.

Additionally, since only the material subject to an applied electric field undergoes piezoelectric strain, a strain discontinuity arises at the interface between the active and inactive areas which may lead to cracks forming at, and propagating away from, the terminated ends of the interdigitated electrodes 24. The cracks may affect the structural integrity of the actuator and reduce its reliability and operational life. Furthermore, it is necessary to control the dimensions of the margins 26 during manufacture since unequal margins 26 may lead to asymmetry of inactive zones 28 on opposing sides of the stack 12, causing bending moments and thus further stressing the stack 12 during operation.

Cracks may also propagate inwardly from the point of contact between the internal electrodes 24 and the external current conducting elements 28, 20. This arises as the material is weakened by micro-cracking caused by the alloying effects of the compositions of the internal electrodes and the external conducting elements 18, 20 during manufacture.

Common to actuators of the type described is the need to connect the side-mounted conductors 18, 20 to a power supply and difficulties arise in achieving adequate electrical connection whilst maintaining sufficient insulation of the entire stack 12. In addition, some form of electrical connector must be accommodated by the injector assembly reducing both the space available for the actuator itself and increasing the complexity and hence cost of the assembly as a whole.

It is an object of the present invention to provide a piezoelectric actuator device which substantially avoids or at least alleviates some of the aforementioned problems and further, to reduce the manufacturing complexity and hence cost of such a device.

According to the present invention, there is provided a piezoelectric actuator device including a stack of one or more piezoelectric elements and means for applying a voltage across the one or more piezoelectric elements to cause energisation thereof, wherein the means includes a pair of opposing electrodes and positive and negative conductor members receivable by respective first and second channels disposed internal to the stack.

The positive and negative conductor members are received by the first and second channels respectively, so as to make contact with the opposing electrode pair. For the purposes of the description, the term - internal to the stack - refers to a location inwardly of the outer edges of the stack i.e. within or inside the stack boundary.

Preferably, the stack comprises a plurality of piezoelectric elements wherein adjacent elements share a common electrode and the first and second channels are defined by apertures in the piezoelectric elements and corresponding electrodes.

The piezoelectric actuator device has particular benefit when employed in a fuel injector. Since the conductor members are located inside the stack, they are not subject to a high pressure environment together with high moisture content so avoiding corrosion and undue stress of the conductor members. In addition, the difficulties associated with insulating a stack having external conductors can be avoided.

Preferably, the apertures of a first group of alternate ones of the electrodes are shaped so as to be in electrical contact with the positive conductor member and the apertures of a second group of remaining alternate ones of the electrodes are shaped so as to be in electrical contact with the negative conductor member. Therefore, an electric field is generated in each piezoelectric element, the polarity of which alternates between successive elements.

Still preferably, the electrodes of each pair are planar and mutually parallel, and the conductor members intersect the electrodes substantially perpendicular to the plane of the electrodes.

Arranging the conductor members internal to the stack in this manner avoids inactive zones being located on opposing faces of the stack as is common in the prior art. Consequently, the effects of the inactive zones "clamping" the active zones, for instance, cracking in the elements and bending of the stack, can be largely prevented.

Whilst it is envisaged that the apertures (hence the channels) may be substantially circular, they may alternatively be polygonal (e.g. square or rectangular). Similarly, although the apertures are preferably disposed on an axis of symmetry of an electrode, they may also be disposed offset from said axis. This allows design freedom in the design of a piezoelectric device in accordance with the invention.

In an alternative embodiment of the invention, the positive and negative conductors may comprise one or more segments having a side wall and first and second end faces. In addition, at least one of the end faces of a segment may be domed.

Still alternatively, the positive and negative conductors may comprise a material that is substantially a liquid, or at least non-solid, at some operating conditions, so as largely to avoid problems due to metal fatigue occurring at the electrical and mechanical interface between the electrodes and conductor members.

From another aspect, the invention lies in a method for constructing a piezoelectric actuator device comprising: providing a stack of one or more piezoelectric elements, providing an opposing pair of electrodes for each element to permit application of a voltage across the one or more piezoelectric elements to cause energisation thereof and receiving positive and negative conductor members into first and second channels disposed internal to the stack.

The step of arranging the stack so as to receive the positive and negative conductor members internal to the stack may further comprise: providing two or more apertures in the or each of the one or more elements and in each of the electrodes; arranging the piezoelectric elements in a stack so that a first set of the apertures align to define the first channel and a second set of the apertures align to define the second channel; inserting the positive conductor member through the first channel so as to make contact with alternate ones of the electrodes; and inserting the negative conductor member through the second channel so as to make contact with remaining alternate ones of the electrodes.

For convenience of manufacture, the steps of providing the two or more apertures in the elements and the electrodes may be carried out prior to arranging the elements in a stack.

Alternatively, the piezoelectric elements may firstly be arranged in a stack and subsequently the at least two apertures may be formed in the piezoelectric elements by forming the first and second channels through the stack by drilling, for example.

The invention will now be described, by way of example only, with reference to the accompanying drawings in which:
Figure 1 is a perspective view of a known piezoelectric actuator device;
Figure 2 is a schematic side view of the piezoelectric actuator device of Figure 1;
Figure 3 is a side view of the piezoelectric actuator device in Figure 1;
Figures 4a and 4b are sectional views of the piezoelectric actuator device in Figure 3 through the lines A-A and B-B showing two consecutive internal electrode layers;
Figure 5 is a section view of a piezoelectric actuator device of a first embodiment of the present invention;
Figure 6 is an enlarged side view of the piezoelectric actuator device in Figure 5;
Figures 7a and 7b are sectional views of the piezoelectric actuator device in Figure 6 though the lines A-A and B-B showing two successive internal electrode layers;
Figure 8 is an enlarged side view of a piezoelectric actuator device of another embodiment of the present invention, and;
Figure 9 is an enlarged side view of a piezoelectric actuator device of a further alternative embodiment of the present invention;

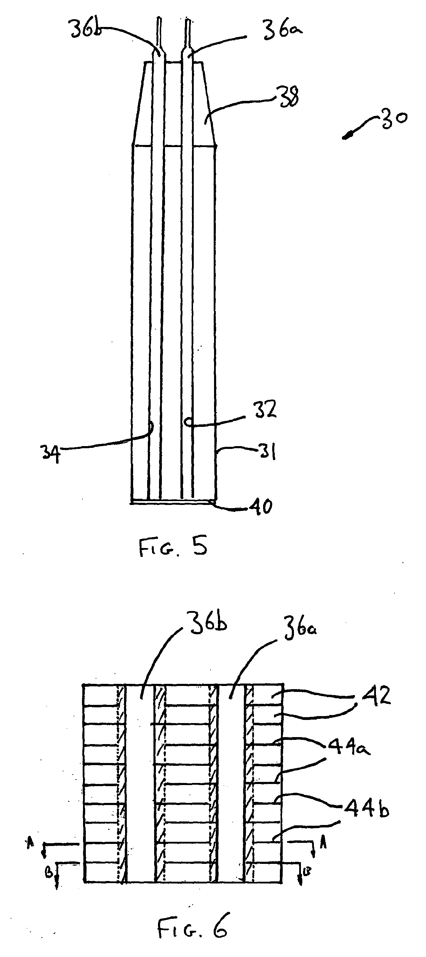

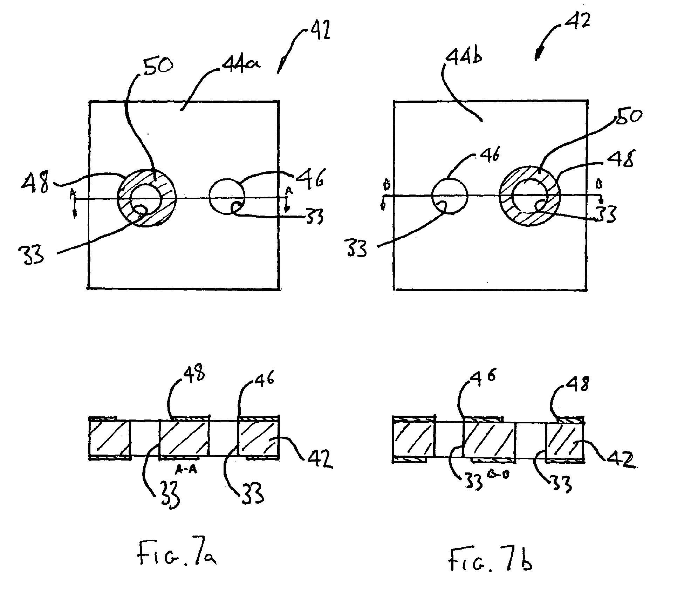

Referring firstly to Figures 5 and 6, there is shown a piezoelectric actuator device 30 having a stack 31 of piezoelectric elements being provided with first and second longitudinal channels or passages 32, 34 for receiving conductor means. The conductor means include rod-like conducting members 36a, 36b each of which extends through a respective one of the channels 32, 34. The stack 31 comprises a first end piece 38 and a second end piece 40 and a plurality of piezoelectric elements or layers 42, adjacent elements 42 being spaced apart by internal electrodes 44a, 44b, which are arranged to be substantially parallel to the first and second end pieces 38, 40 of the device 30. The first end piece 38 is in the form of a cap and the second end piece 40 is in the form of a plate or tile. Alternate ones of the electrodes 44a, 44b form a first group of electrodes and the remaining alternate ones of the electrodes form a second group of electrodes, whereby the electrodes 44a of the first group are in electrical connection with the first conductor member 36a and the electrodes 44b of the second electrode group are in electrical connection with the second internal conductor member 36b. The first and second end pieces 38, 40 are disposed at the ends of the stack 31 and enclose the conductor members 36a, 36b inside the stack 31, and so seal the stack 31, against high pressure fuel for example.

The conductor members 36a, 36b extend along the length of the stack 31 and protrude through the first end piece 38 wherein the ends of the conductors 36a, 36b are adapted for attachment to a suitable electrical connector (not shown). In this embodiment, the first and second pieces 38, 40 are formed from the same material as the piezoelectric elements 42 and become an integral part of the stack 31 following manufacture. The pieces 38, 40 thus provide support to the stack so that the stack may withstand high pressures. However, it will be appreciated that another ceramic composition or indeed any other material appropriate to effect sealing of the stack may alternatively be used, for example, aluminium.

Referring to Figures 7a and 7b, for each piezoelectric element, the internal electrode layers 44a, 44b extend to the edges of the element 42 and are provided with a first generally circular aperture 48 of relatively large diameter and a second generally circular aperture 46 of smaller diameter. Each piezoelectric element 42 is also provided with first and second apertures or openings 33. The piezoelectric element 42 and its associated electrodes 44a, 44b are arranged so that the first, larger aperture 48 in the electrode 44a, 44b aligns with one of the openings 33 in the element 42 and the second, smaller aperture 46 aligns with the other opening 33 in the element 42, so when formed into a stack 31 of elements 42, the aligned openings 33 and apertures 46, 48 define respective first and second channels 32, 34 which are substantially disposed on a symmetrical axis of the elements 42. The small aperture 46 has a diameter substantially equal to the opening 33 and so an electrical connection is formed between the electrode 44a, 44b and the conductor (not shown). Conversely, the second conductor (not shown) is isolated from the electrode layer 44a since the aperture 48 has a larger diameter (and therefore larger area) than the opening 33. It will be appreciated that successive electrode layers in the stack are oriented at 180 degrees to one another (e.g. referring to Figures 7a and 7b which show successive layers). In use, a voltage is applied across the conductors 36a, 36b so that they are of positive and negative polarity and therefore, an inactive zone 50 (also shown in Figure 6) surrounds each internal conductor 36a, 36b. In contrast, prior art multi-layer devices as exemplified in Figures 1 to 3, have an electrode layer 24 printed over a portion of the adjacent piezoelectric element 22 whilst leaving an inactive zone 26 at an edge of the piezoelectric element 22.

In the above-described arrangement, the size of the inactive region is significantly reduced, as compared to known prior art devices, whilst the main advantage of low applied voltages associated with existing multi-layered stacks is maintained. Instead of an inactive zone being located on opposing surfaces of the stack 31 and clamping the active zone, relatively small inactive zones 50 are formed internal to the stack and located around either one of the conductor members 36a, 36b. This reduces the likelihood of cracking between the terminated ends of the internal electrodes.

As well as reducing the size of the inactive regions, the piezoelectric device 30 of the present invention avoids the need for components such as conductors to be attached to the external surface of the stack 31, thus eliminating the manufacturing step required to affix the conductors.

A further advantage with the above arrangement is that the shape of the piezoelectric device is not constrained by the necessity to apply external conductors to faces of the device, so the shape of the device may be designed to suit a specific application. For instance, the stack 31 may be circular or even polygonal in cross section to make efficient use of space within an injector chamber of a fuel injector. Another disadvantage of existing fuel injector designs is that the external conductors (i.e. 18, 20 in Figure 1) also require insulation from a moisture-bearing environment to prevent chemical attack. In practice, forming an effective insulating layer over the stack and the attached components can be difficult to achieve and the insulating material may be forced into any cracks or pits on the surface of the stack by high pressure fuel. This may lead to internal shorting as the cracks are driven across the active region.

With reference to Figure 7a and 7b, although the apertures are disposed in alignment on a lateral axis of the element 42 within the stack 31, the apertures may also be disposed offset from the axis to provide further design freedom for a specific application.

The piezoelectric elements or layers 42 in the device of the present invention may be fabricated by the so called "green sheet" method, as is well known in the art. The composition of the layers may be constituted by a ferroelectric ceramic of the lead zirconate titanate (PZT) group although it will be appreciated that piezoelectric ceramics of other compositions may also be used. A ceramic sheet (green sheet) is fabricated comprising a plurality of ceramic layers and internal electrode sheets are then screen printed, using a printing mask to form the apertures 46, 48 onto its surface. The internal electrodes 44a, 44b are preferably an alloy of silver and palladium, although any other conductive material such as copper or nickel or any alloy thereof may be used as an alternative. It will be appreciated that the positioning of the printing mask must be accurately controlled so that the apertures in the electrode layers align with one another when formed into a stack to avoid a short circuit between electrodes and conductors of opposite polarity. Successive piezoelectric and electrode layers are alternately laminated until the required stack thickness is reached. The laminate is then formed into an integral monolithic block by sintering. The internal channels 32, 34 of the stack 31 are formed by core-drilling, micro-laser VIA drilling or any appropriate method, and the conductor members 36a, 36b are then inserted into their respective channels. The monolith is then diced into individual samples. It will be appreciated that although the channel formation and conductor member insertion steps may be more readily performed on a monolithic block, they could alternatively be performed on individual samples following dicing of the monolith. Still alternatively, the apertures 33 may be formed in the piezoelectric elements 42 before or after the electrodes are screen printed.

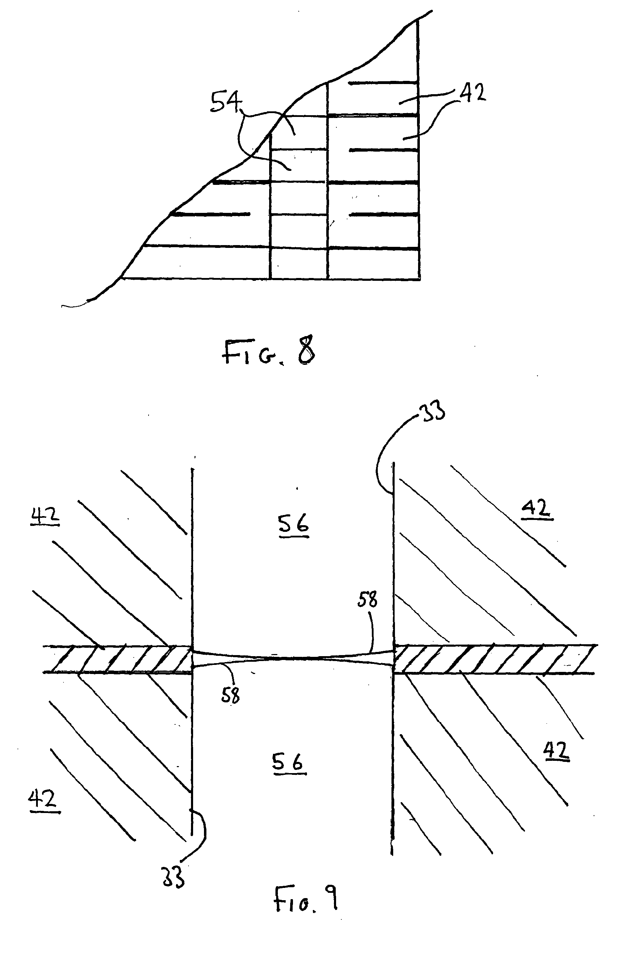

An alternative embodiment is shown in Figure 8 and is similar to that as described with reference to Figures 5 to 7, except that the conductors 36a, 36b are formed of a plurality of segments 54 disposed end to end (each segment associated with a piezoelectric element 42). When the piezoelectric elements 42 are stacked to form a stack 31, the conductor segments 54 will effectively create a single conductor member, equivalent to 36a, 36b in Figures 5 and 6. A segment 54 can be accommodated by an opening 33 in the piezoelectric element 42 prior to assembly of the stack 31, which may be a more convenient means of manufacture as opposed to inserting a conductor member into a drilled channel of a stack 31.

It is important in this embodiment that extension and contraction of each element 42 due to the applied electric field does not cause relative movement between the conductor segments 54, so that electrical contact between the segments is broken. However, thermal expansion of the segments 54 at operating temperatures may ensure electrical contact between the segments 54 is maintained at all times. Electrical disconnection of the segments 54 can also be avoided by a further embodiment, as shown in Figure 9, in which the conductor segments 56 include domed or convex end faces 58 to compensate for the relative movement between segments 56 and so maintain electrical connection during extension and contraction of the stack. The segments 54, 56 in the above embodiments made be composed of invar (RTM), platinum or titanium for example.

In a further alternative embodiment, the conductors 36a, 36b may comprise a non-cohesive solid conducting material such as a paste or a powder or still alternatively, a low melting point alloy such as gallium or bismuth for example. Such a material may substantially liquefy when the piezoelectric actuator device reaches its operating temperature (typically 100°C to 150°C). Still alternatively, the conducting material may be a liquid at operating temperature, for example mercury. In this example, the conducting means includes conductor pins (not shown) formed in the first end piece 38 and which extend into the channels 32, 34 to effect electrical connection from the power supply (not shown) to the liquid conductor material. It will be appreciated that stresses at the electrical interface between the conductors 36a, 36b and the electrode layers 44a, 44b will be reduced in this embodiment.

In another embodiment, the conductors 36a, 36b may alternatively be tubular more readily to comply with thermal expansion and irregularities of the channels 32, 34. Furthermore, the first and second end pieces 38, 40 may alternatively be formed of aluminium, for example, to impart additional strength to the stack.

It will be understood by those who practice the invention and those skilled in the art, that various modifications and improvements may be made to the invention without departing from the scope of the disclosed concept. Accordingly, reference should be made to the claims and other conceptual statements herein rather than the foregoing specific description in determining the scope of the invention.

## Claims

1. A piezoelectric actuator device (30) including a stack (31) of one or more piezoelectric elements (42) and means for applying a voltage across the one or more piezoelectric elements (42), wherein the means includes a pair of opposing electrodes (44a, 44b) and positive and negative conductor members (36a, 36b) receivable by respective first and second channels (32, 34) disposed internal to the stack (31).

2. The piezoelectric actuator device (30) as claimed in Claim 1, comprising a plurality of piezoelectric elements (42), wherein adjacent elements (42) share a common electrode (44a, 44b).

3. The piezoelectric actuator device (30) as claimed in Claims 1 or 2, wherein the first and second channels (32, 34) are defined by apertures (33, 46, 48) provided in the piezoelectric elements (42) and the electrodes (44a, 44b).

4. The piezoelectric actuator device (30) as claimed in Claim 3, wherein the apertures (46, 48) of a first group of alternate ones of the electrodes (44a, 44b) are shaped so as to be in electrical contact with the positive conductor member (36a, 36b) and the apertures (46, 48) of a second group of remaining alternate ones of the electrodes (44a, 44b) are shaped so as to be in electrical contact with the negative conductor member (36a, 36b).

5. The piezoelectric device (30) as claimed in Claim 3 or Claim 4, wherein the apertures (46, 48) of each electrode (44a, 44b) comprise a first aperture (48) having a larger area than that of the second aperture (46).

6. The piezoelectric device (30) as claimed in any one of Claims 3 to 5, wherein the apertures (46, 48) are generally circular.

7. The piezoelectric device (30) as claimed in any one of Claims 3 to 5, wherein the apertures (46, 48) are polygonal.

8. The piezoelectric device (30) as claimed in any one of Claims 3 to 7, wherein the apertures (46, 48) are disposed on an axis of symmetry of a corresponding electrode (44a, 44b).

9. The piezoelectric device (30) as claimed in any one of Claims 1 to 8, wherein the electrodes (44a, 44b) of each pair are planar and mutually parallel, and wherein the conductor members (36a, 36b) intersect the electrodes (44a, 44b) substantially perpendicular to the plane of the electrodes (44a, 44b).

10. The piezoelectric device (30) as claimed in any one of Claims 1 to 9, wherein the positive and negative conductor members (36a, 36b) comprise one or more segments (54) having a side wall and first and second end faces.

11. The piezoelectric device (30) as claimed in Claim 10, wherein at least one of the end faces is domed.

12. The piezoelectric device (30) as claimed in any one of Claims 1 to 9, wherein the conductor means includes a material that is non-solid.

13. A fuel injector having a piezoelectric device as claimed in any one of Claims 1 to 12.

14. A method for manufacturing a piezoelectric device (30) comprising:
providing a stack (31) of one or more piezoelectric elements (42);
providing an opposing pair of electrodes (44a, 44b) for each element (42) to permit application of a voltage across the one or more piezoelectric elements (42) and receiving positive and negative conductor members (36a, 36b) into first and second channels (32, 34) disposed internal to the stack (31).

15. The method as claimed in Claim 14, further comprising;
providing two or more apertures (33, 46, 48) in the or each of the one or more elements (42) and in each of the electrodes (44a, 44b);
arranging the piezoelectric elements (42) in a stack (31) so that a first set of the apertures (33, 46, 48) align to define the first channel (32) and a second set of the apertures (33, 46, 48) align to define the second channel (34);
inserting the positive conductor member (36a) through the first channel (32) so as to make contact with alternate ones of the electrodes (44a); and,
inserting the negative conductor member (36b) through the second channel (34) so as to make contact with remaining alternate ones of the electrodes (44b).

16. The method as claimed in Claim 15, wherein the steps of providing the two or more apertures (33, 46, 48) in the elements (42) and the electrodes (44a, 44b) are carried out prior to arranging the elements (42) in a stack (31).

17. The method as claimed in Claim 15, further comprising initially arranging the piezoelectric elements (42) in a stack (31) and subsequently forming the two or more apertures (33) in the piezoelectric elements (42) by forming the first and second channels (32, 34) through the stack (31).

18. The method as claimed in Claim 17, wherein the step of forming the first and second channels (32, 34) includes drilling the first and second channels (32, 34) through the stack (31).
